# EUROPÄISCHE PATENTANMELDUNG

(11) **EP 1 001 493 A2**
(43) Veröffentlichungstag der Anmeldung: **17.05.2000**
(21) Anmeldenummer: 99121720.9
(22) Anmeldetag: 03.11.1999
(51) Int. Cl.: H01R 13/405, H05K 5/00

(54) **Baugruppe aus einem Halteteil und einem darin eingegossenen Kontaktstift**

(30) Priorität: 16.11.1998 DE 19852730
(71) Anmelder: Harting KGaA, 32325 Espelkamp (DE)
(72) Erfinder: Harting, Dietmar, Dipl.-kfm., 32339 Espelkamp (DE); Heimann, Thomas, Dipl.-Ing., 32339 Espelkamp (DE); Ciezarek, Marek, Dipl.-Ing., 32312 Lübbecke (DE)

(57) **Zusammenfassung**

Es wird eine Baugruppe aus einem Halteteil (10) aus elektrisch isolierendem Material und aus einem darin eingegossenen elektrischen Kontaktstift (20) beschrieben, der einen gasdichten elektrischen Anschluß durch das Halteteil (10) hindurch bereitstellt, wobei der Kontaktstift (20) an seinen beiden axialen Enden mit jeweils einem Anschlußbereich (22, 24) versehen ist, der die Schnittstelle zu einem an den Kontaktstift (20) anzuschließenden Bauteil bildet, und zwischen den Anschlußbereichen (22, 24) mit einem Fixierbereich (28), der für eine Verankerung des Kontaktstiftes (20) in dem Halteteil (10) sorgt, und einem Vergußbereich (26) versehen ist, an dem eine Vergußmasse (16) anliegt, die am Halteteil (10) in einem Aufnahmebereich (14) anliegt.

## Beschreibung

Die Erfindung bezieht sich auf eine Baugruppe aus einem Halteteil aus elektrisch isolierendem Material und aus einem darin eingegossenen elektrisehen Kontaktstift, der einen gasdichten elektrischen Anschluß durch das Halteteil hindurch bereitstellt.

Eine solche Baugruppe dient dazu, ein in einem gasdicht abgeschlossenen Gehäuse angeordnetes elektrisches oder elektronisches Gerät anzuschließen. Hierfür dienen die Kontaktstifte, die das Halteteil, das beispielsweise ein Teil der Wand der Gehäuses sein kann, gasdicht durchdringen.

Bei einer erfindungsgemäßen Baugruppe aus einem Halteteil und einem elektrischen Kontaktstift ist vorgesehen, daß der Kontaktstift an seinen beiden axialen Enden mit jeweils einem Anschlußbereich versehen ist, der die Schnittstelle zu einem an den Kontaktstift anzuschließenden Bauteil bildet, und daß der Kontaktstift zwischen den Anschlußbereichen mit einem Fixierbereich, der für eine Verankerung des Kontaktstiftes in dem Halteteil sorgt, und einem Vergußbereich versehen ist, an dem eine Vergußmasse anliegt, die am Halteteil in einem Aufnahmebereich anliegt. Das Halteteil der erfindungsgemäßen Baugruppe hat also mehrere Funktionen Zum einen dient es als mechanischer Halt für die Kontaktstifte. Diese sind in ihrem Fixierbereich geeignet gestaltet, so daß es zu einer guten mechanischen Verbindung zwischen dem Material des Halteteils und den Kontaktstiften kommt. Zum anderen dient das Halteteil zur elektrischen Isolierung. Da das Material des Halteteils elektrisch isolierend ist, werden sowohl die Kontaktstifte gegeneinander als auch gegenüber einer Gehäusewand isoliert, an der das Halteteil angebracht ist. Dies ist relevant, falls die Gehäusewand elektrisch leitend ist. Alternativ kann die Gehäusewand auch unmittelbar von dem Halteteil mit den darin eingegossenen Kontaktstiften gebildet sein. Schließlich dient das Halteteil als Aufnahme für eine zusätzliche Vergußmasse, die an dem Kontaktstift anliegt und für eine Verbesserung der Gasdichtigkeit sorgt. Der auf diese Weise erhaltene Anschluß bildet eine Gasdichtigkeit bei mittleren Überdrücken bis etwa 12 Bar sowie Unterdrücken bis etwa 10 mbar.

Gemäß einer bevorzugten Ausführungsform ist vorgesehen, daß der Fixierbereich einen Abschnitt mit rechteckigem Querschnitt aufweist, an den sich auf jeder Seite ein Bund anschließt. Diese Gestaltung bietet eine besonders hohe Haltekraft im Halteteil sowohl in axialer als auch in radialer Richtung. Ferner kann ein etwaiges Drehmoment, das um die Längsachse des Kontaktstiftes herum wirksam ist, zuverlässig in das Halteteil eingeleitet werden.

Gemäß der bevorzugten Ausführungsform der Erfindung ist weiterhin vorgesehen, daß der Vergußbereich zylindrisch mit Einschnürungen ausgebildet ist. Diese Einschnürungen, die vorzugsweise als Umfangsnuten mit V-förmigem Querschnitt ausgestaltet sind, führen dazu, daß bei einem Druckanstieg im Gehäuseinneren die Vergußmasse in die Nuten hineingepreßt wird Auf diese Weise ergibt sich zusätzlich zur Adhäsion der Vergußmasse an der Oberfläche des Kontaktstiftes ein weiterer Dichteffekt durch die auftretende Druckbeaufschlagung.

Gemäß der bevorzugten Ausführungsform der Erfindung ist weiterhin vorgesehen, daß der Aufnahmebereich nach Art einer Stufenbohrung ausgeführt ist, deren kleinster Durchmesser größer ist als der Außendurchmesser des Vergußbereichs. Der Aufnahmebereich dient zum einen dazu, die Vergußmasse sicher aufzunehmen, so daß sie gegen äußere Verletzungen geschützt ist Zum anderen dient sie dazu, dafür zu sorgen, daß die Vergußmasse bei einem Druckaufbau im Inneren des Gehäuses sowohl an das Halteteil als auch an den Vergußbereich angedrückt wird. Dies verstärkt die Dichtwirkung.

Vorzugsweise ist die Vergußmasse dauerelastisch, so daß der von ihr bereitgestellte Dichteffekt über einen langen Zeitraum aufrechterhalten bleibt.

Vorteilhafte Ausgestaltungen der Erfindung ergeben sich aus den Unteransprüchen.

Die Erfindung wird nachfolgend unter Bezugnahme auf eine bevorzugte Ausführungsform beschrieben, die in den beigefügten Zeichnungen dargestellt ist. In diesen zeigen:
- Figur 1 in einer Schnittansicht eine erfindungsgemäße Baugruppe;
- Figur 2 in vergrößertem Maßstab das Detail X von Figur 1;
- Figur 3 in vergrößertem Maßstab das Detail Y von Figur 1; und
- Figur 4 den bei der Baugruppe von Figur 1 verwendeten Kontaktstift.

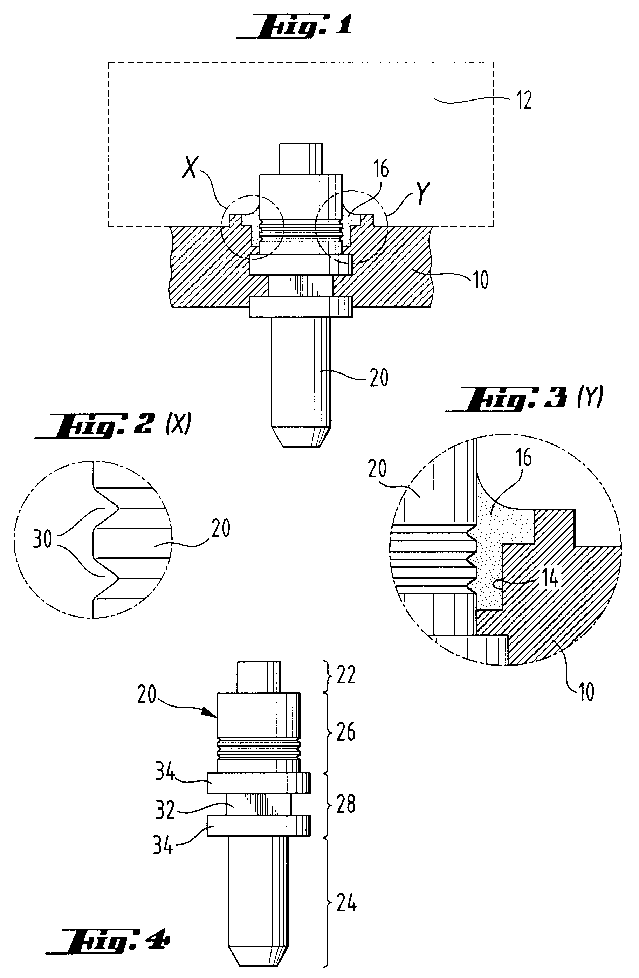

In Figur 1 ist schematisch eine erfindungsgemäße Baugruppe gezeigt. Diese besteht aus einem Halteteil 10 und einem Kontaktstift 20.

Das Halteteil 10 besteht aus einem elektrisch isolierenden Material, beispielsweise Kunststoff, und bildet einen Teil der Wand eines schematisch angedeuteten Gehäuses 12. Im Inneren des Gehäuses 12 kann ein (nicht gezeigtes) elektrisches oder elektronisches Gerät angeordnet sein, das mittels mehreren der Kontaktstifte 20 angeschlossen werden kann.

Der Kontaktstift 20 (siehe auch die Figuren 2 und 4) besteht aus einem elektrisch leitenden Material und weist an seinen beiden axialen Enden jeweils einen Anschlußbereich 22 bzw. 24 auf. Die Anschlußbereiche dienen dazu, einen elektrisch leitenden Kontakt mit dem Kontaktstift auf an sich bekannte Weise herzustellen, beispielsweise durch einen Schraub-, Niet-, Löt- oder Steckanschluß. Bei der gezeigten Ausführungsform ist der Anschlußbereich 22 als Nietkopf ausgebildet, während der Anschlußbereich 24 als Steckkontaktstift ausgebildet ist.

Zwischen den beiden Anschlußbereichen 22, 24 ist der Kontaktstift 20 mit einem Vergußbereich 26 sowie einem Fixierbereich 28 versehen. Der Vergußbereich 26 hat einen allgemein zylindrischen Querschnitt und ist mit drei Einschnürungen versehen, die als Umfangsnuten 30 mit V- förmigem Querschnitt ausgestaltet sind. Der Fixierbereich 28 weist einen Abschnitt 32 mit quadratischem Querschnitt sowie auf jeder Seite einen Bund 34 auf.

Der Kontaktstift 20 wird unmittelbar in das Material des Halteteils 10 eingegossen, wobei es zu einer formschlüssigen Verbindung zwischen dem Fixierbereich 28 des Kontaktstiftes 20 und dem Material des Halteteils 10 kommt. Der Abschnitt 32 mit rechteckigem Querschnitt sowie der Bund 34 auf jeder Seite dieses Abschnitts dienen dazu, sämtliche auf den Kontaktstift 20 einwirkenden Kräfte zuverlässig in das Halteteil 10 einzuleiten.

Beim Eingießen des Kontaktstiftes 20 in das Halteteil 10 wird um den Vergußbereich 26 des Kontaktstiftes 20 herum ein Aufnahmebereich 14 (siehe insbesondere Figur 3) abgeformt, der nach Art einer Stufenbohrung ausgebildet ist, wobei der kleinere Durchmesser der Stufenbohrung größer ist als der Durchmesser des Vergußbereichs 26. Der Aufnahmebereich 14 ist so gestaltet, daß der Abschnitt der gebildeten Stufenbohrung mit größerem Durchmesser auf der vom Fixierbereich 28 abgewandten Seite liegt und daß die dem Fixierbereich 28 zugewandte Vorderfläche des Aufnahmebereichs in einem axialen Abstand von der dem Vergußbereich 26 zugewandten Stirnfläche des auf dieser Seite angeordneten Bundes 34 liegt. Der Aufnahmebereich 14 grenzt also nicht unmittelbar an den Fixierbereich 28 des kontaktstiftes 20 an, sondern ist durch einen Materialabschnitt des Halteteils 10 von diesem getrennt.

In den Aufnahmebereich 14 wird eine dauerelastische Vergußmasse 16 eingefüllt, die sowohl an der Wandung des Aufnahmebereichs 14 als auch an der Wandung des Kontaktstiftes 20 im Vergußbereich 26 dicht anliegt. Insbesondere füllt die Vergußmasse die Nuten 30 im Vergußbereich 26 aus.

Aufgrund der Ausgestaltung des Vergußbereichs 26 am Kontaktstift 20 und des Aufnahmebereichs 14 am Halteteil 10 verstärkt ein auf die Vergußmasse 16 einwirkender Über- oder Unterdruck die Dichtwirkung, so daß es zu einer sehr guten Gasdichtigkeit im Bereich der Durchführung des Kontaktstiftes 20 durch das Halteteil 10 kommt.

## Patentansprüche

1. Baugruppe aus einem Halteteil (10) aus elektrisch isolierendem Material und aus einem darin eingegossenen elektrischen Kontaktstift (20), der einen gasdichten elektrischen Anschluß durch das Halteteil (10) hindurch bereitstellt, wobei der Kontaktstift (20) an seinen beiden axialen Enden mit jeweils einem Anschlußbereich (22, 24) versehen ist, der die Schnittstelle zu einem an den Kontaktstift (20) anzuschließenden Bauteil bildet, und zwischen den Anschlußbereichen (22, 24) mit einem Fixierbereich (28), der für eine Verankerung des Kontaktstiftes (20) in dem Halteteil (10) sorgt, und einem Vergußbereich (26) versehen ist, an dem eine Vergußmasse (16) anliegt, die am Halteteil (10) in einem Aufnahmebereich (14) anliegt.

2. Baugruppe nach Anspruch 1, dadurch gekennzeichnet,
daß der Fixierbereich (28) einen Abschnitt mit rechteckigem Querschnitt (32) aufweist, an den sich auf jeder Seite ein Bund (34) anschließt.

3. Baugruppe nach einem der Ansprüche 1 und 2, dadurch gekennzeichnet,
daß der Vergußbereich (26) zylindrisch mit Einschnürungen (30) ausgebildet ist.

4. Baugruppe nach Anspruch 3, dadurch gekennzeichnet,
daß der Vergußbereich mit Umfangsnuten (30) versehen ist, die einen V-förmigen Querschnitt haben.

5. Baugruppe nach Anspruch 4, dadurch gekennzeichnet,
daß drei Umfangnuten (30) vorgesehen sind.

6. Baugruppe nach einem der Ansprüche 1 bis 5, dadurch gekennzeichnet,
daß der Aufnahmebereich (14) nach Art einer Stufenbohrung ausgeführt ist, deren kleinster Durchmesser größer ist als der Außendurchmesser des Vergußbereichs (26).

7. Baugruppe nach einem der vorhergehenden Ansprüche, dadurch gekennzeichnet,
daß die Vergußmasse (16) dauerelastisch ist.
